# EUROPEAN PATENT SPECIFICATION

(11) **EP 2 508 645 B1**
(45) Date of publication and mention of the grant of the patent: **25.02.2015**
(21) Application number: 11161343.6
(22) Date of filing: 06.04.2011
(51) Int. Cl.: C23C 14/54, C23C 14/24

(54) **Evaporation system with measurement unit**
Verdampfungssystem mit Messeinheit
Système d'évaporation avec unité de mesure

(43) Date of publication of application: 10.10.2012
(73) Proprietor: Applied Materials, Inc., Santa Clara, CA 95054 (US)
(72) Inventor: Hoffmann, Uwe, 63755 Alzenau (DE)
(74) Representative: Zimmermann & Partner

(56) References cited:
- EP-A1- 2 261 388
- EP-A1- 2 469 268
- LARDON M ET AL: "Thin film production with a new fully automated optical thickness monitoring system", PROCEEDINGS OF SPIE; CONF- THIN FILM TECHNOLOGIES II - 15-17 APRIL 1986 - INNSBRUCK, AUSTRIA, THE INTERNATIONAL SOCIETY FOR OPTICAL ENGINEERING SPIE, USA, vol. 652, 15 April 1986 (1986-04-15), pages 10-14, XP008118252, ISSN: 0277-786X

## Description

### TECHNICAL FIELD OF THE INVENTION

Embodiments of the present invention relate to an evaporation system for use in a vacuum installation, a coating installation including the evaporation system, and a method of using the same. Embodiments of the present invention particularly relate to an evaporation system, typically for organic material, with a measurement system for measuring a coating rate, a coating installation having such an evaporation system and a method for use thereof.

### BACKGROUND OF THE INVENTION

Organic evaporators are an essential tool for the production of organic light-emitting diodes (OLED). OLEDs are a special type of light-emitting diodes in which the emissive layer comprises a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED displays is considerably less than that of traditional LCD displays. Further, the fact that OLEDs can be manufactured onto flexible substrates opens the door to new applications such as roll-up displays or even displays embedded in clothing.

The functionality of an OLED depends on the coating thickness of the organic material. This thickness has to be within a predetermined range. In the production of OLEDs, it is therefore important that the coating rate at which the coating with organic material is effected lies within a predetermined tolerance range. In other words, the coating rate of an organic evaporator has to be controlled thoroughly in the production process.

Thereby, the deposition rate for OLED applications, but also for other evaporation processes, typically requires high accuracy rate over a comparably long time. There is a plurality of measurement systems for measuring the deposition rate of evaporators online. However, these measurements suffer from either insufficient accuracy and/or insufficient stability over the desired time period.

Alternatively, it is known in the art that the deposited layer of a substrate that has been processed is analyzed after the deposition is complete in order to determine the coating rate. In this case, the feedback control of the deposition system is only possible with a certain delay. In particular, this procedure can result in one or more substrates being coated with a layer that is out of range before the control can take corrective action.

EP 2 261 388 A1 describes a deposition rate monitor device for monitoring the deposition rate of a vapor on a substrate. The deposition rate monitor device includes a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture.

In view of the above, it is the object of the present invention to provide an evaporation system, a coating installation, and a method for measuring the evaporation rate to a substrate that overcome at least some of the problems in the art.

### SUMMARY OF THE INVENTION

In light of the above, an evaporation system according to independent claim 1, and a method according to independent claim 13 are provided. Further aspects, advantages, and features of the present invention are apparent from the dependent claims, the description, and the accompanying drawings.

According to one embodiment, an evaporator for evaporating a material, e.g., organic material, onto a substrate is provided. The evaporator includes a guiding means for guiding the material towards at least one opening nozzle, wherein the guiding means includes a measurement outlet for a portion of the material, particularly with an evaporation direction different from the evaporation direction of the at least one opening nozzle. The evaporator further includes a first measurement system configured for generating a first signal correlated with a deposition rate of the evaporator and having a first detector positioned for being coated by the material, and a second optical measurement system for generating a second signal correlated with the deposition rate of the evaporator and wherein the second signal is based on the portion of the material of the measurement outlet.

According to one embodiment, an evaporation apparatus for depositing material on a substrate is provided. The apparatus includes a chamber for depositing the material on the substrate and an evaporator, wherein the evaporator is provided within the chamber. The evaporator includes a guiding means for guiding the material towards at least one opening nozzle, wherein the guiding means includes a measurement outlet for a portion of the material, particularly with an evaporation direction different from the evaporation direction of the at least one opening nozzle. The evaporator further includes a first measurement system configured for generating a first signal correlated with a deposition rate of the evaporator and having a first detector positioned for being coated by the material, and a second optical measurement system for generating a second signal correlated with the deposition rate of the evaporator and wherein the second signal is based on the portion of the material of the measurement outlet.

According to a further embodiment, a method of operating an evaporation apparatus for a material, e.g., organic material is provided. The method includes guiding a first portion of evaporated material onto a substrate via opening nozzles, guiding a second portion of evaporated material onto a first detector via a measurement outlet, moving a test substrate portion between the measurement outlet and the first detector to deposit the test substrate portion with the second portion of evaporated material, removing the test substrate portion from between the measurement outlet and the first detector to again guide the second portion of evaporated material onto the first detector via the measurement outlet, measuring a signal corresponding with a layer thickness of the layer of evaporated material deposited on the test substrate portion with an optical measurement system, and using the signal for calibration of the first detector.

### BRIEF DESCRIPTION OF THE DRAWINGS

A full and enabling disclosure, including the best mode thereof, to one of ordinary skill in the art is set forth more particularly in the remainder of the specification, including reference to the accompanying figures wherein:
- Figs. 1 to 8: show various embodiments of the evaporation system as seen from a substrate to be coated;
- Fig. 9: show various embodiments of the evaporation system in a side view perspective; and
- Fig. 10: shows a flow chart of a method of operating an evaporator according to embodiments described herein.

### DETAILED DESCRIPTION OF EMBODIMENTS

Reference will now be made in detail to the various embodiments of the invention, one or more examples of which are illustrated in the figures. Each example is provided by way of explanation of the invention, and is not meant as a limitation of the invention. For example, features illustrated or described as part of one embodiment can be used on or in conjunction with other embodiments to yield yet a further embodiment. It is intended that the present invention includes such modifications and variations.

Embodiments of the present invention provide an evaporation system, henceforth also called evaporator, for applying vapor to a substrate in a vacuum chamber at a coating rate. The evaporator has a distribution manifold including an inlet for receiving the vapor and an evaporation section having a first outlet for applying the vapor to a substrate. The evaporation section defines a first fluidal path for the vapor to go from the inlet to the first outlet.

The coating rate of the evaporator depends on the pressure of the material which has to be evaporated in the distribution pipe. This pressure corresponds to the vapor pressure of the material. Thus, there is a sufficiently high pressure to enable the measurement of a significant signal of a characteristic property of the vapor. The embodiments described herein relate to the application of an organic material to a substrate. However, embodiments of the present invention may also be applied for the coating of non-organic substances, i.e., inorganic substances.

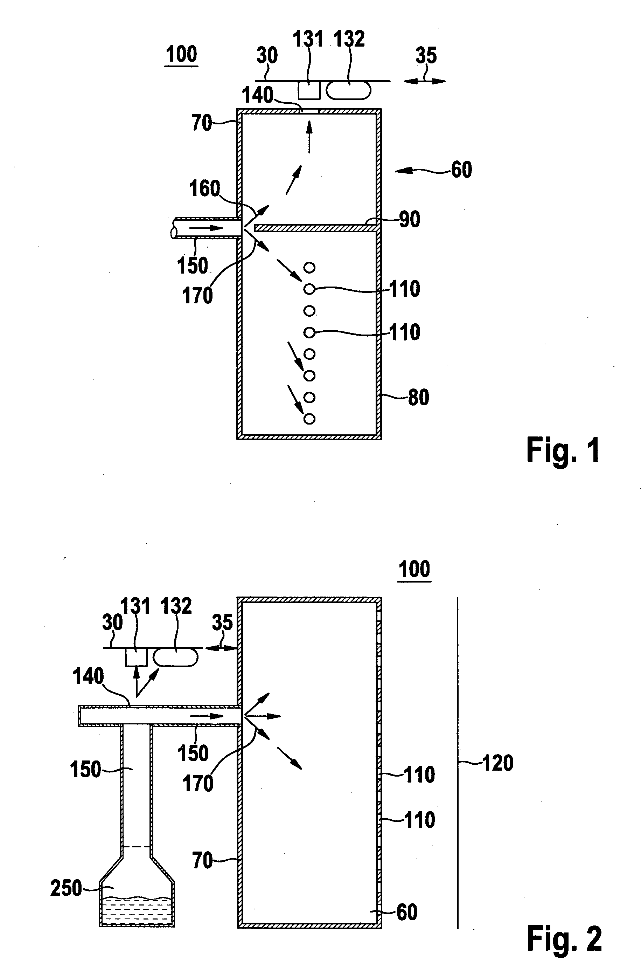

Fig. 1 shows a first embodiment of the evaporator 100. The distribution manifold 60 of the evaporator includes a deposition outlet, typically in the form of a multitude of nozzle outlets, which together form a first outlet 110. According to typical embodiments, the distribution manifold can be a distribution pipe or a showerhead. For evaporator applications, particularly a distribution pipe can be utilized. The diameter of a typical distribution pipe according to the present invention is between 1 cm and 10 cm, more typically between 4 cm and 6 cm. When evaporating a substrate with organic material, the pressure within the distribution pipe, which is larger than the pressure outside, causes the organic vapor to stream out of the distribution manifold towards a substrate (not shown in Fig. 1). In the view shown in Fig. 1, the substrate would be positioned above the paper plane. In typical methods for coating a substrate, the organic vapor is applied to the substrate in a vacuum atmosphere. The term vacuum shall refer to a pressure of 1 Pa and below. Typically, the nozzle outlets are shaped and arranged such that the flow of vapor of one nozzle outlet overlaps with the flow of vapor of a next neighbor nozzle outlet on the substrate surface.

The distribution manifold of Fig. 1 is divided into two sections by a separator 90. Vapor streaming into the distribution manifold 60 (direction of flow represented by arrows), typically from a heated crucible (not shown) via supply tube 150, is divided by separator 90. One portion 170 of the incoming vapor is guided into the evaporation section 80, from where it leaves distribution manifold 60, e.g., a distribution pipe, through first outlet 110, which typically includes a plurality of nozzles. Another portion 160 of the vapor is guided into measurement section 70. After passing the measurement section, the vapor leaves distribution pipe 100 through second outlet 140, which is a measurement outlet. From there, it is typically guided out of a coating installation in which the pipe 100 is employed. The division of the vapor by separator 90 is typically designed such that a larger amount of vapor is guided into the evaporation section 80, typically about 70 % to 99.5 %, more typically 80 % to 97 %. Respectively, a much smaller amount is guided into the measurement section. This may be achieved by placing separator 90 such that the cross-section of the opening leading into the measurement section 70 is significantly smaller than the opening leading to evaporation section 80. Generally, the arrows used herein only symbolize the flow direction of vapor. The number or density of arrows per area is neither related to a vapor density nor indicative for any quantitative parameter. According to typical embodiments, which can be combined with other embodiments described herein, the distribution manifold, e.g., the distribution pipe, can be heated to a temperature of about 100° C to 700° C

In Fig. 1, a first measurement section 131 and a second measurement section 132 is supported by a support 30 such that typically either the first measurement section or the second measurement section can be positioned in front of the measurement opening 140. In Fig. 1, this is indicated by arrow 35. According to an alternative solution, the second measurement section could be moved such that it is placed between the measurement opening 140 and the first measurement section. Thereby, the first measurement section does not need to be moved.

According to embodiments described herein, the first measurement system is configured for generating a first measurement signal correlated with the deposition rate of the evaporator. Typically, the first measurement system includes one or more detectors for a deposition rate, which provides a high accuracy, such as +- 3% or better, particularly +- 1% or better. This can be, for example, a Quartz crystal measurement system, wherein an oscillating quartz crystal is evaporated with the measurement portion of the vapor and the oscillation frequency depends on the amount of material to be deposited on the quartz crystal. This is a commonly used measurement system; for example, Cygnus™ from Inficon can be utilized. According to some embodiments, which can be combined with other embodiments described herein, four or more, for example, ten or 12, or even more detectors (e.g., quartz crystals) can be provided in the first measurement system. Typically, a quartz crystal carousel could be used.

Even though the first measurement system might provide the desired accuracy, the operation life is not sufficient even if more than one detector is provided. This is due to the fact that the crystals are deposited and there is a limited amount of material to be deposited on the detector if the accuracy should be maintained in the desired range. Further, the detectors of the first measurement system having the desired accuracy on a short time scale can experience a sudden drop or raise of the signal, which is uncorrelated to a drop or raise of the deposition rate. Yet further, if more than one detector is used in order to provide for a longer operation life of the first detection system, a change of the detector can result in a drop or raise of the generated signal.

In light of the above, according to embodiments described herein, a second measurement system 132 is provided. The second measurement system is provided within a chamber of an evaporation apparatus and can generate a second signal correlated to the deposition rate. Accordingly, if a sudden drop or raise of a signal of the first measurement system is provided, the second signal of the second measurement system can be used to have a calibration from an independent measurement system. According to typical embodiments, which can be combined with other embodiments described herein, the second measurement system is an optical measurement system. For example, the optical measurement system 132 can include a test substrate holder or test substrate support, which is configured for positioning a test substrate in front of the measurement outlet 140 such that a test substrate is coated with the evaporated material. Further, the optical measurement system includes an optical measurement unit for measuring the thickness of the deposited layer.

According to typical embodiments, which can be combined with other embodiments described herein, the measuring with the optical measurement system is selected from the group consisting of: an optical absorption measurement; an interferometer measurement; an ellipsometry measurement; an optical reflection measurement; an optical transmission measurement; a photoluminescence measurement; an optical reflection measurement in wavelength range including wavelength below 400 nm; an optical transmission measurement in wavelength range including wavelength below 400 nm; and combinations thereof.

The second measurement system typically includes a source for electromagnetic radiation, e.g. a light source, which can be, for instance, a laser or a traditional white or colored light source having a specific spectral distribution. It is also possible that the light source includes a light emitting unit having a wide distribution and a filter in front to allow only a specific range of wavelengths to pass through. It is also possible that the light source represents the end of a fiber optic cable. In other words, in embodiments of the present invention, there may be fiber optics arranged for transmitting the light to the second measurement unit. The detectors could also be connected via fiber optics. This would enable the use of certain detectors which otherwise would not properly function in particular environments.

Fig. 2 shows another embodiment, wherein a crucible 250 is filled or partially filled with the material to be evaporated, such as an organic material to be coated on a substrate. The crucible is in fluid communication with the distribution manifold 60 having opening nozzles 110 via the supply tube 150. The supply tube 150 and the distribution manifold 60 provide a guiding means for the evaporated material, which is directed towards the substrate 120. As shown in Fig.2, the measurement outlet is provided in the guiding means. Figure 2 shows the measurement outlet to be within the supply tube configured for guiding the evaporated material from the crucible 250 to the distribution manifold 60. Thereby, at least the second measurement system is configured for generating a second signal correlated with the deposition rate of the evaporator, wherein the second signal is based on the portion of the material of the measurement outlet. Thereby, the second measurement signal can be located remotely from, i.e. distant from, the deposition area where the substrate 120 is coated.

The distribution manifold 60 of the evaporator 100 includes a deposition outlet, typically in form of a multitude of nozzle outlets, which together form a first outlet 110. In typical methods for coating a substrate, the organic vapor is applied to the substrate in a vacuum atmosphere as described herein. The term vacuum shall refer to a pressure of 1 Pa and below. Typically, the nozzle outlets are shaped and arranged such that the flow of vapor of one nozzle outlet overlaps with the flow of vapor of a neighboring nozzle outlet on the substrate surface.

The vapor guiding means, i.e., the supply tube 150 and the distribution manifold 60, is provided with a measurement outlet such that one portion 170 of the incoming vapor is guided into the distribution manifold 60, e.g., a distribution pipe. Another portion 160 of the vapor is guided towards the measurement systems 131 and 132. The division of the vapor is typically designed such that a larger amount of vapor is guided into the evaporation section 80, typically about 70 % to 99.5 %, more typically 80 % to 97 %. Respectively, a much smaller amount is guided into the measurement section. This may be achieved by providing the measurement outlet 140 with an opening size, which is sufficiently small, e.g., from 0.5 mm to 4 mm.

Similarly to Fig.1, a first measurement section 131 and a second measurement section 132 is supported in Fig. 2 by a support 30 such that typically either the first measurement section or the second measurement section can be positioned in front of the measurement opening 140. This is indicated by arrow 35. According to an alternative solution, the second measurement section could be moved such that it is placed between the measurement opening 140 and the first measurement section. Thereby, the first measurement section does not need to be moved.

According to embodiments described herein, the first measurement system is configured for generating a first measurement signal correlated with the deposition rate of the evaporator. Typically, the first measurement system includes one or more detectors for a deposition rate, which provides a high accuracy, such as +- 3% or better, particularly +- 1% or better. This can be, for example, a quartz crystal measurement system, wherein an oscillating quartz crystal is evaporated with the measurement portion of the vapor and the oscillation frequency depends on the amount of material to be deposited on the quartz crystal. Further, a second measurement system 132 is provided. The second measurement system is provided within the evaporation apparatus and/or as a portion of the evaporator and can generate a second signal correlated to the deposition rate. According to typical embodiments, which can be combined with other embodiments described herein, the second measurement system is an optical measurement system. For example, the optical measurement system 132 can include a test substrate holder or test substrate support, which is configured for positioning a test substrate in front of the measurement outlet 140 such that a test substrate is coated with the evaporated material. Further, the optical measurement system includes an optical measurement unit for measuring the thickness of the deposited layer.

In typical embodiments, the measurement of the second measurement system is performed in a non-contacting way. The elements of the measurement device, such as a source for electromagnetic radiation and a detector for electromagnetic radiation, for example a light source and a detector, are typically arranged outside the distribution pipe. In typical embodiments, the measurement device includes one or more, e.g., two, detectors and one or more, e.g., two, light sources. Generally, the term "light" within the present application refers to all kinds of electromagnetic radiation. In typical embodiments, the light emitted has at least a wavelength portion below 400 nm, and particularly below 400 nm and above 300 nm. Visible light between 400 nm and 700 nm is also often used, and also infrared radiation with wavelengths from 0,7 µm to 20 µm, more typically from 2 µm to 16 µm, is frequently applied. The latter frequencies cover the typical vibrational spectra of organic materials, which may be conveniently used for rate measurement during application of organic materials. The at least one light source may be a laser, a white light lamp, or the like. In a typical embodiment, a laser with tunable wavelength is applied. The at least one detector may be a photodiode, a pin-diode, photo multiplier, or the like. It is also possible to provide a spectrometer in order to analyze an electromagnetic spectrum.

Typically, guiding means, i.e., the supply tube 150 and the distribution manifold 60 can be made of quartz glass. Generally, the distribution manifold can be a distribution pipe, which can be a hollow body having at least one first outlet for applying vapor to a substrate, wherein the first outlet is preferably a nozzle, typically a plurality of nozzles. The distribution pipe is typically connected with a feeding unit, such as a crucible and a supply tube, for feeding the distribution pipe with vapor. The feeding unit is typically connected to the interior of the distribution pipe via an inlet, whereby the feeding unit or supply tube may be an integral part of the distribution manifold. Typically, the distribution pipe includes between 15 and 200, more typically between 20 and 100 nozzle outlets. The diameter of the nozzle outlets is typically between 0.1 mm and 5 mm, more particular between 1 mm and 2 mm. The distribution pipe can be shaped as a tube or the like. In other embodiments, the distribution pipe is a shower head. Typically, the pipe is heated during the application process in order to avoid condensation of the vapor in the pipe. To this end, electrical heating elements may be arranged at the outer surface of the pipe.

If the numbers of nozzles and their respective area of openings are small in comparison to the total size/volume of the distribution pipe/tube, then the pipe is considered to be a closed volume. The pressure within the tube is more stable and results in better coating processes and pressure measurements. Typically, the combined area of the first outlet, respectively the nozzles, and measurement outlet is smaller than 10 % of the inner area of the pipe, more typically smaller than 5 %.

The guiding means, i.e., the supply tube and the distribution manifold, typically includes two sections. The evaporation section includes the first outlet, typically a plurality of nozzles, for applying vapor to a substrate. This section defines a first fluidal path for the vapor, namely the inlet to the first outlet, and subsequently to be supplied to a substrate to be coated. Secondly, the distribution pipe includes a measurement opening as a second outlet. The second outlet is intended for displacing vapor from the measurement section, wherein the vapor is typically displaced out of the deposition region of the coating installation. According to typical embodiments, which can be combined with other embodiments described herein, the evaporation direction of the measurement outlet is different from the evaporation direction of the at least one opening nozzle of the first outlet. Thereby, coating of the substrate with a portion of the vapor, which is provided for deposition rate measurement, can be avoided and/or the arrangement of the evaporator can be simplified, e.g., for maintenance purposes. Thus, the measurement section defines a second fluidal path for the vapor from the inlet to the second outlet. Typically, the second outlet is adapted such that the vapor from the measurement section is not applied to the substrate. After the deposition rate measurement, the portion of the vapor, which is provided for deposition rate measurement, is typically either guided to the opening of a vacuum pump in the coating installation, or might also be collected in the installation for subsequent disposal. That is, the vapor from the measurement section may be applied to a surface other than the substrate inside the coating installation for later disposal.

According to other embodiments, which can be combined with embodiments described herein, the evaporation direction of the measurement outlet can also be substantially similar from the evaporation direction of the at least one opening nozzle of the first outlet. Thereby, however, the measurement unit receiving vapor from the measurement outlet might not be positioned away from the substrate to be processed.

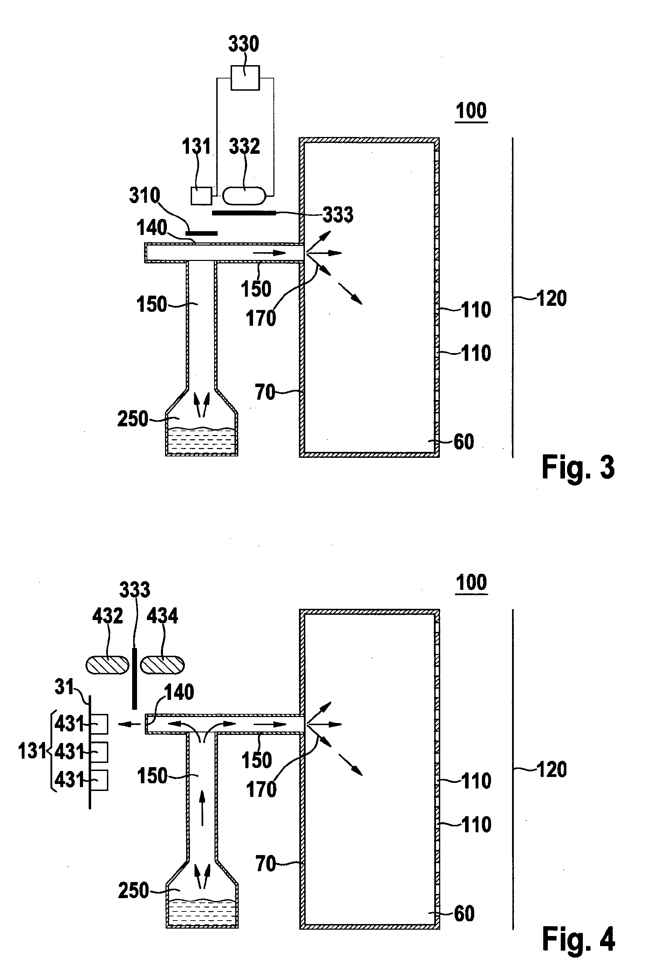

Fig. 3 illustrates yet further embodiments and additional or alternative modifications of embodiments described herein. A crucible 250 is filled or partially filled with the material to be evaporated, such as an organic material to be coated on a substrate. The crucible is in fluid communication with the distribution manifold 60 having opening nozzles 110 via the supply tube 150. As described above, the supply tube 150 and the distribution manifold 60 provide a guiding means for the evaporated material, which is directed towards the substrate 120. As shown in Fig.2, the measurement outlet 140 is provided in the supply tube 150. Thereby, at least the second measurement system, which is configured for generating a second signal correlated with the deposition rate of the evaporator and wherein the second signal is based on the portion of the material of the measurement outlet, can be located remote from, i.e. distant from, the deposition area where the substrate 120 is coated.

According to some embodiments, which can be combined with other embodiments described herein, a shutter 310 for blocking a portion of the vapor from the measurement outlet 140 is provided. The shutter can be positioned facing the measurement outlet. Thereby, the time period during which the detector, e.g., the oscillating crystal, of the first measurement system is deposited can be reduced. For example, the shutter can be opened once a minute or once every three or five minutes for a measurement time of 5 seconds to 120 seconds, such as for example about 60 seconds to 90 seconds. Accordingly, the operation life of the first measurement system can be increased because less material is deposited on the detector of the first measurement system. Further, the shutter can be closed during switching between the first and the second measurement system. For example, the shutter can be closed during a time period when the test substrate 333 is positioned for being deposited by the portion of the vapor from the measurement outlet 140. Thereby, a defined deposition time on the test substrate can be provided in order to increase the accuracy of the second signal correlated with the deposition rate of the evaporator.

Within Fig.3, a first measurement section 131 and a second measurement section 132 is shown. The first measurement system 131 can include an oscillating crystal as described in more detail with respect to other embodiments. The second measurement system includes a test substrate 333 and an optical measurement system for measuring the thickness of a layer deposited on the test substrate 333. According to typical embodiments, which can be combined with other embodiments described herein, the measuring with the optical measurement system is selected from the group consisting of: an optical absorption measurement; an interferometer measurement; and ellipsometry measurement; an optical reflection measurement, an optical transmission measurement, a photoluminescence measurement, an optical reflection measurement in wavelength range including wavelength below 400 nm, particularly below 400 nm and above 300 nm, and optical transmission measurement in wavelength range including wavelength below 400 nm, and particularly below 400 nm and above 300 nm, and combinations thereof. The second measurement system typically includes light source which can be, for instance, a laser or a traditional white or colored light source having a specific spectral distribution and a light detector. This light source and the detector are illustrated by element 332 in Fig. 3. It is also possible that the light source is provided as the end of a fiber optic cable. In other words, in embodiments of the present invention, there may be a fiber optics arranged for transmitting the light to the test substrate 333. The detectors could also be connected via fiber optics.

According to some embodiments, which can be combined with other embodiments described herein, the evaporator can further include a controller 330. The controller has a first inlet connected to the second measurement system or the detector thereof, respectively, and is configured for receiving the signal of the second measurement system, which is correlated with the deposition rate of the evaporator. The controller has a first outlet connected to the first measurement system 131. Thereby, a signal for online calibration of the first measurement system can be provided. Alternatively, the connection between the first measurement system and the controller can be used for providing a signal from the first measurement system 131 to the controller and an evaluation of the signal from the first measurement system including the calibration thereof can be conducted in the controller 330.

According to embodiments described herein, the first measurement system is configured for generating a first measurement signal correlated with the deposition rate of the evaporator. Typically, the first measurement system includes one or more detectors for a deposition rate, which provides a high accuracy, such as +- 3% or better, particularly +- 1% or better. This can be, for example, a Quartz crystal measurement system, wherein an oscillating quartz crystal is evaporated with the measurement portion of the vapor and the oscillation frequency depends on the amount of material to be deposited on the quartz crystal. Further, a second measurement system 132 is provided. The second measurement system is provided within the evaporation apparatus and/or as a portion of the evaporator and can generate a second signal correlated to the deposition rate. According to typical embodiments, which can be combined with other embodiments described herein, the second measurement system is an optical measurement system. For example, the optical measurement system 132 can include a test substrate holder or test substrate support, which is configured for positioning a test substrate in front of the measurement outlet 140 such that a test substrate is coated with the evaporated material. Further, the optical measurement system includes an optical measurement unit for measuring the thickness of the deposited layer.

Figure 4 illustrates yet further embodiments of an evaporator 100 described herein. Material to be evaporated, for example, organic material is provided in the crucible 250 and is evaporated therein. The portion 170 of the evaporated material is guided through the supply tube 150 to the distribution manifold 60. The evaporated material is directed through nozzle openings 110 onto substrate 120. Another portion of the evaporated material is guided by supply tube 150 to the measurement outlet 140. The second portion of the evaporated material, i.e., the portion passing through measurement opening 140, is used for generating signals being correlated to that deposition rate of the evaporators 100. As shown in figure 4, according to some embodiments, the first measurement system 131 can include a plurality of detectors 431. For example, the plurality of detectors 431 can be provided on a support 31. Typically, the support could be a carousel, which can be rotated such that one detector 431 can measure that deposition rate at a time and after a certain time the next detector is moved in a position to face the measurement outlet 140 such that the next detector 431 can be used for the deposition rate measurement. The one or more detectors for a measuring the deposition rate provide a high accuracy, such as +- 3% or better, particularly +- 1% or better. This can be, for example, a quartz crystal measurement system, wherein an oscillating quartz crystal is evaporated with the measurement portion of the vapor and the oscillation frequency depends on the amount of material to be deposited on the quartz crystal.

According to some embodiments, which can be combined with other embodiments described herein, four or more, for example, ten or 12, or even more detectors (e.g., quartz crystals) can be provided in the first measurement system. Typically, a quartz crystal carousel could be used as the support 31.

The second measurement system includes a test substrate 333 and an optical measurement system for measuring the thickness of a layer deposited on the test substrate 333. Within Fig. 4, the test substrate can be moved downward in a coating position and the coated layer thickness can be determined in a measurement position, which is illustrated in Fig. 4. The second measurement system typically includes light source 432 which can be, for instance, a laser or a traditional white or colored light source having a specific spectral distribution as described herein and a light detector 434 as described herein. It is also possible that the light source referred to as reference numeral 432 can be the end of a fiber optic cable. In other words, in embodiments of the present invention, there may be a fiber optics arranged for transmitting the light to the test substrate 333. The detectors could also be connected via fiber optics.

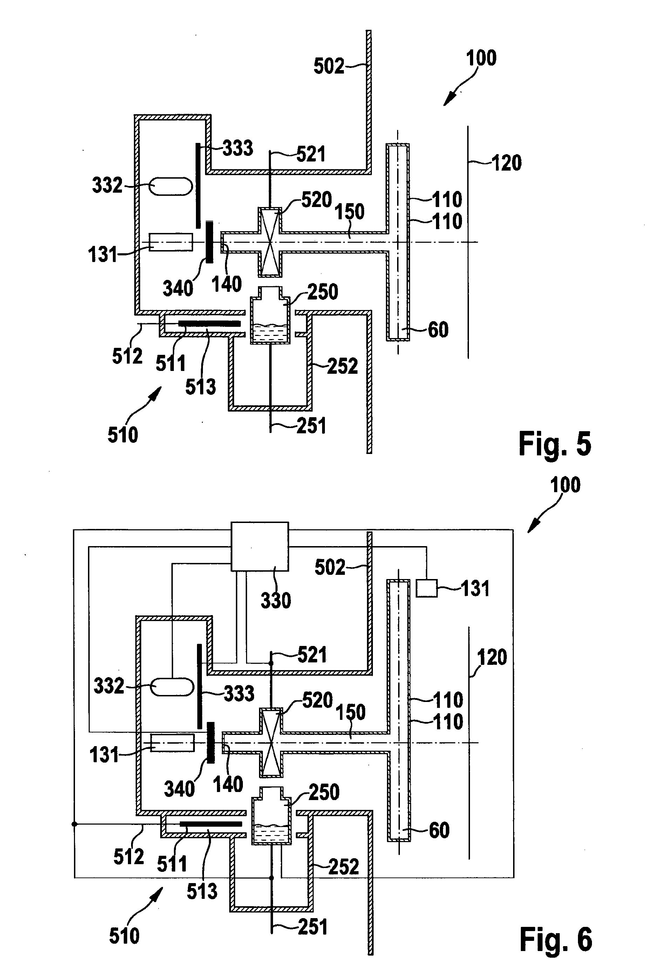

Fig. 5 illustrates yet further embodiment of the evaporator 100. The vapor guiding means includes the distribution manifold 60 and the supply tube 150. The evaporator includes a deposition outlet, typically in the form of a multitude of nozzle outlets, which together form a first outlet 110. According to typical embodiments, the distribution manifold can be a distribution pipe or a showerhead. For evaporator applications, particularly a distribution pipe can be utilized. When evaporating a substrate 120 with organic material, the pressure within the guiding means, which is larger than the pressure outside, causes the organic vapor to stream out of the distribution manifold towards a substrate 120. The vapor guiding means, i.e., the supply tube 150 and the distribution manifold 60, is further provided with a measurement outlet. One portion of the incoming vapor is guided into the distribution manifold 60, e.g., a distribution pipe. Another portion of the vapor is guided towards the measurement systems. The division of the vapor is typically designed such that a larger amount of vapor is guided into the evaporation section 80, typically about 70 % to 99.5 %, more typically 80 % to 97 %. Respectively, a much smaller amount is guided into the measurement section. This may be achieved by providing the measurement outlet 140 with an opening size, which is sufficiently small, e.g., from 0.5 mm to 4 mm. According to typical embodiments, which can be combined with other embodiments described herein, the distribution manifold, e.g., the distribution pipe, and the supply tube can be heated to a temperature of about 100°C to 700°C

In Fig. 5, a first measurement section 131 and a second measurement section including the measurement device 332 and the test substrate 333 are provided. The measurement systems and the measurement outlet 140 are positioned such that typically either the first measurement section or the test substrate 333 of second measurement section can be positioned in front of the measurement opening 140.

According to embodiments described herein, the first measurement system can include one or more, such as 6 to 18 quartz crystal measurement detectors, wherein an oscillating quartz crystal is evaporated with the measurement portion of the vapor and the oscillation frequency depends on the amount of material to be deposited on the quartz crystal. This is a commonly used measurement system; for example, Cygnus™ from Inficon can be utilized.

Even though the first measurement system might provide the desired accuracy, the operation life is generally not sufficient even if more than one detector is provided. This is due to the fact that the crystals are deposited and there is a limited amount of material to be deposited on the detector if the accuracy should be maintained in the desired range. Further, the detectors of the first measurement system having the desired accuracy on a short time scale can experience a sudden drop or raise of the signal, which is uncorrelated to a drop or raise of the deposition rate. Yet further, if more than one detector is used in order to provide for a longer operation life of the first detection system, a change of the detector can result in a drop or raise of the generated signal.

In light of the above, according to embodiments described herein, a second measurement system having a test substrate 333 and layer thickness measuring device 332 is provided. The second measurement system is provided within a chamber of the evaporation apparatus and can generate a second signal correlated to the deposition rate. Accordingly, if a sudden drop or raise of a signal of the first measurement system is provided, the second signal of the second measurement system can be used to have a calibration from an independent measurement system.

According to typical embodiments, which can be combined with other embodiments described herein, the second measurement system can be an optical measurement system configured for measuring a layer thickness which has been deposited on the test substrate 333. According to typical optional modifications of the embodiments described herein, the second measurement system, for example, the optical measurement device and particularly the optical sensor can be shielded with a shield configured for reducing exposure of the optical measurement device to thermal radiation.

According to some embodiments, which can be combined with other embodiments described herein, an increase in layer thickness can be measured. Thereby, for example, the thickness of a coated layer can be measured before the test substrate is moved in front of the measurement opening 140, the substrate 133 is moved in front of the measurement opening 140, evaporated material is deposited on the test substrate 133 and the thickness of the layer can be measured again in order to determine the deposition rate during the time at which the test substrate has been exposed to the vapor of the measurement outlet. As shown in Fig. 5, the measurement opening can, according to some embodiments, which can be combined with other embodiments described herein, be oriented to have an evaporation direction, which is opposite to the evaporation direction of the outlet nozzles 110. Thereby, a maintenance-friendly configuration can be provided.

According to typical embodiments, which can be combined with other embodiments described herein, the measuring with the optical measurement system is selected from the group consisting of: an optical absorption measurement; an interferometer measurement; an ellipsometry measurement; an optical reflection measurement; an optical transmission measurement; a photoluminescence measurement, an optical reflection measurement in wavelength range including wavelength below 400 nm, particularly below 400 nm and above 300 nm; an optical transmission measurement in wavelength range including wavelength below 400 nm, particularly below 400 nm and above 300 nm; and combinations thereof.

The evaporator 100 shown in figure 5 includes a shutter 310 for blocking a portion of the vapor from the measurement outlet 140 is provided. The shutter can be positioned facing the measurement outlet. Thereby, the time period during which the detector, e.g., the oscillating crystal, of the first measurement system 131 is deposited can be reduced. For example, the shutter can be opened once a minute or once every three or five minutes for a measurement time of about 5 seconds to 120 seconds, such as for example about 60 seconds to 90 seconds. Accordingly, the operation life of the first measurement system can be increased because less material is deposited on the detector of the first measurement system. Further, the shutter can be closed during a time period when the test substrate 333 is positioned for being deposited by the portion of the vapor from the measurement outlet 140. Thereby, a defined deposition time on the test substrate can be provided in order to increase the accuracy of the second signal correlated with the deposition rate of the evaporator.

The evaporator 100 shown in Fig. 5 further includes a housing portion 502, a valve 520, and a crucible chamber 252. The housing portion 502 can, for example, be connected to a vacuum chamber portion for depositing evaporated material on substrates 120 provided therein. According to some embodiments, which can be combined with other embodiments described herein, the crucible 250 can be moved out of and moved into a crucible chamber 252, which can be locked by a crucible valve shutter assembly 510. For example, the crucible shutter assembly can include a shutter housing 513, in which the shutter 511 can be moved by actuator 512. According to some embodiments, the crucible chamber 252 and an enclosure of the chamber portion 502 have an opening for passing the crucible 250 therethrough, i.e., from a position within the crucible chamber 252 to a position at which the crucible is connected to the supply tube. Thereby, the system can be maintained in an evacuated state during exchange of the crucible and/or the material to be deposited. If the crucible is provided in the position within the crucible chamber (the lower position in Fig. 5), the shutter 511, typically a vacuum valve, can be closed such that the crucible chamber 252 can be opened for an exchange of the crucible and/or re-filling of the material therein. Further, according to some embodiments, which can be combined with other embodiments described herein, the valve 520 can be moved from a closed position to an open position with actuator 521. If the valve 520 is in a closed position, no or only little vapor can enter the supply tube and, thus, the distribution manifold 60 and the measurement region respectively. In an open position of valve 520, the material, which is evaporated in crucible 252, can enter the supply tube 150 for being guided towards the substrate 120 and towards the measurement region.

Fig. 6 illustrates yet further embodiments of an evaporator 100. The vapor guiding means includes the distribution manifold 60 and the supply tube 150. The evaporator includes a deposition outlet, typically in form of a multitude of nozzle outlets, which together form a first outlet 110. According to typical embodiments, the distribution manifold can be a distribution pipe or a showerhead. As compared to the embodiment shown in Fig. 5, the first measurement system is provided facing the distribution manifold 60. Thereby, the evaporation rate of the evaporator is measured at a position in close vicinity to, for example, directly adjacent to the substrate to be coated with the evaporated material. The direction of evaporated material, which is deposited on the detector of the first measurement system, can, in this configuration, be the same direction as the evaporation direction for coating the substrate. It is further possible, that the plurality of nozzles outlets 110 configured for guiding the evaporated material towards the substrate 120 is provided such that the first detection unit is provided in front of one portion of the plurality of nozzle outlets. According to embodiments described herein, the first measurement system can include one or more, such as 6 to 18 quartz crystal measurement detectors, wherein an oscillating quartz crystal is evaporated with the measurement portion of the vapor and the oscillation frequency depends on the amount of material to be deposited on the quartz crystal. This is a commonly used measurement system; for example, Cygnus™ from Inficon can be utilized. According to yet further embodiments, which can be combined with other embodiments described herein, a further shutter (not shown) can be provided between the first measurement system 131 and the distribution manifold.

The second measurement system is provided facing the measurement outlet 140, i.e., in a direction with an evaporation direction different from the nozzle outlets. Beyond the above described differences, a first measurement section 131 and a second measurement section including the measurement device 332 and the test substrate 333 can be provided similar to Figs. 1 to 4, and particularly Fig. 5. The second measurement system is provided within the evaporator system, yet outside the evaporator, and can generate a second signal correlated to the deposition rate. Accordingly, if a sudden drop or raise of a signal of the first measurement system is provided, the second signal of the second measurement system can be used to have a calibration from an independent measurement system.

According to typical embodiments, which can be combined with other embodiments described herein, the second measurement system can be an optical measurement system configured for measuring a layer thickness which has been deposited on the test substrate 333. According to some embodiments, which can be combined with other embodiments described herein, an increase in layer thickness can be measured. Thereby, for example, the thickness of a coated layer can be measured before the test substrate is moved in front of the measurement opening 140, the substrate 133 is moved in front of the measurement opening 140, evaporated material is deposited on the test substrate 133 and the thickness of the layer can be measured again in order to determine the deposition rate during the time at which the test substrate has been exposed to the vapor of the measurement outlet. As shown in Fig. 6, the measurement opening can, according to some embodiments, which can be combined with other embodiments described herein, be oriented to have an evaporation direction which is opposite to the evaporation direction of the outlet nozzles 110. Thereby, a maintenance-friendly configuration can be provided.

As shown in Fig. 6, a controller 330 can be connected to the first measurement system 131 and the second measurement system, which can, for example, include the test substrate 333 and the layer thickness measuring device 332. Thereby, a calibration of the high accuracy first measurement system can be provided to also provide for a sufficiently long operational life, e.g., at least 1 week, typically 2 weeks or more, or even 3 weeks or more. Thereby, the operational life can be extended to be synchronized with other maintenance periods. According to yet further embodiments, the controller can also be connected to the crucible to control heating thereof and, thus, the vapor pressure in the system. This can, for example, be done when the deposition rate measurement indicates a drift in deposition rate. The controller might further be used for controlling action of the actuators 252, 512, and 521, and of shutter 310, for allowing coordinated operation of actuators and shutters for different operation modes like evaporation, evaporation including calibration, crucible exchange, or other maintenance steps.

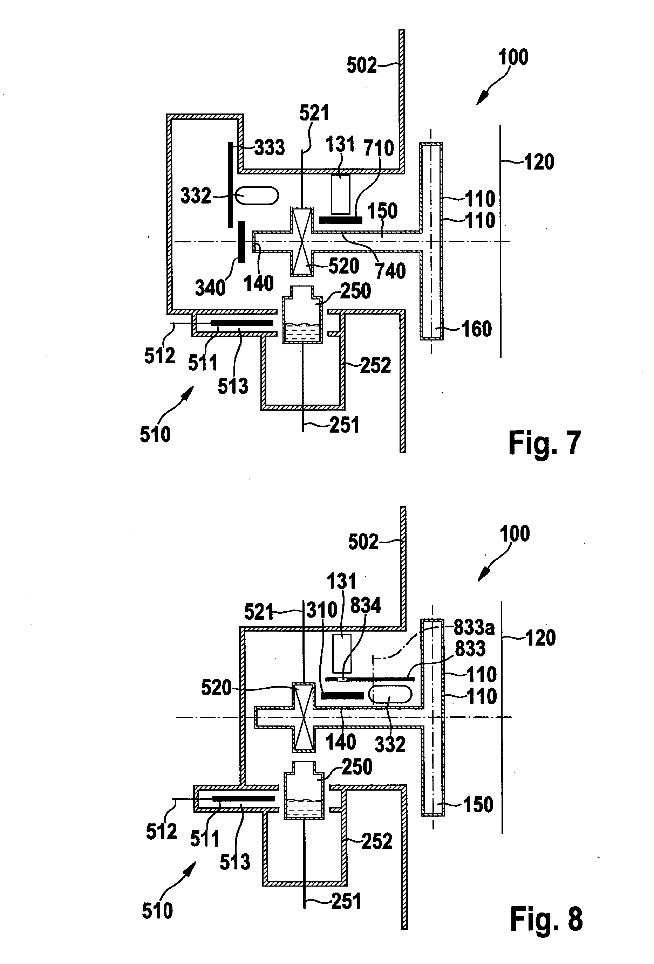

According to yet further embodiments, which are described with respect to Fig. 7, a the first measurement system and the second measurement system can be provided opposite to a first measurement outlet 140 and a second measurement outlet 740. Thereby, the first and the second measurement outlet can be provided in the guiding means for the vapor and particularly in the supply tube 150. As further shown in Fig. 7, a first shutter 310 and a second shutter 710 can be provided, each for blocking the respective portion which is provided from the guiding means for deposition rate measurement purposes. Thereby, shutter 710 can be utilized the time period during which the detector, e.g., the oscillating crystal, of the first measurement system 131 is deposited can be reduced. For example, the shutter can be opened once a minute or once every three or five minutes for a measurement time of about 5 seconds to 120 seconds, such as for example about 60 seconds to 90 seconds. Accordingly, the operation life of the first measurement system can be increased because less material is deposited on the detector of the first measurement system. Further, the further shutter 310 can be closed during a time period when the test substrate 333 is positioned away from the measurement outlet 140 and can be opened for a predetermined time period when the test substrate 333 is position in the deposition position. Thereby, a defined deposition time on the test substrate can be provided in order to increase the accuracy of the second signal correlated with the deposition rate of the evaporator. As described above, according to typical embodiments, which can be combined with other embodiments described herein, the measuring with an optical, second measurement system is selected from the group consisting of: an optical absorption measurement; an interferometer measurement; and ellipsometry measurement; an optical reflection measurement; an optical transmission measurement; a photoluminescence measurement; an optical reflection measurement in wavelength range including wavelength below 400 nm, particularly below 400 nm and above 300 nm; an optical transmission measurement in wavelength range including wavelength below 400 nm; and combinations thereof.

Fig. 8 illustrates yet a further embodiment of the evaporator 100. The vapor guiding means includes the distribution manifold 60 and the supply tube 150. The evaporator includes a deposition outlet, typically in the form of a multitude of nozzle outlets, which together form a first outlet 110. According to typical embodiments, the distribution manifold can be a distribution pipe or a showerhead. For evaporator applications, particularly a distribution pipe can be utilized. When evaporating a substrate 120 with organic material, the pressure within the guiding means, which is larger than the pressure outside, causes the organic vapor to stream out of the distribution manifold towards a substrate 120. The vapor guiding means, i.e., the supply tube 150 and the distribution manifold 60, is further provided with a measurement outlet. One portion of the incoming vapor is guided into the distribution manifold 60, e.g., a distribution pipe. Another portion of the vapor is guided towards the measurement systems. The division of the vapor is typically designed such that a larger amount of vapor is guided into the evaporation section 80, typically about 70 % to 99.5 %, more typically 80 % to 97 %. Respectively, a much smaller amount is guided into the measurement section. This may be achieved by providing the measurement outlet 140 with an opening size which is sufficiently small, e.g., from 0.5 mm to 4 mm. According to typical embodiments, which can be combined with other embodiments described herein, the distribution manifold, e.g., the distribution pipe, and the supply tube can be heated to a temperature of about 100°C to 700°C

In Fig. 8, a first measurement section 131 and a second measurement section including the measurement device 332 and the test substrate 833 are provided. The measurement systems and the measurement outlet 140 are positioned such that typically either the first measurement section or the test substrate 833 of second measurement section can be positioned in front of the measurement opening 140. The second measurement system is provided within the housing portion 502 of the evaporator system and can generate a second signal correlated to the deposition rate. Accordingly, if a sudden drop or raise of a signal of the first measurement system is provided, the second signal of the second measurement system can be used to have a calibration from an independent measurement system. According to typical embodiments, which can be combined with other embodiments described herein, the second measurement system can be an optical measurement system configured for measuring a layer thickness which has been deposited on the test substrate 833.

According to some embodiments, which can be combined with other embodiments described herein, the test substrate 833 is provided as a rotatable test substrate 833, which is configured to be rotated around axis 833a. Further, the test substrate 833 has an opening aperture 834. In a first angular position, the aperture 834 is provided such that the material from the measurement outlet 140 can pass through the opening aperture in order to expose the first measurement system 131 to a portion of the evaporated material, which is intended for the deposition rate measurement. In one or more other angular positions of the rotatable test substrate 833, a portion of the test substrate is positioned in front of the measurement outlet for coating the test substrate. Thereby, a layer thickness of the coated layer on the test substrate or a layer thickness increase of the coated layer on the test substrate can be measured by measuring device 332.

According to some embodiments, which can be combined with other embodiments described herein, an increase in layer thickness can be measured. Thereby, for example, the thickness of a coated layer can be measured before the portion of the test substrate 833, which is to be coated, is moved in front of the measurement opening 140, the portion of the test substrate 833, which is to be coated, is then moved in front of the measurement opening 140, evaporated material is deposited on the test substrate, the portion of the test substrate 833, which has been coated, is moved, i.e., rotated to, in front of the measuring device, and the thickness of the layer can be measured again in order to determine the deposition rate during the time at which the portion of test substrate has been exposed to the vapor of the measurement outlet.

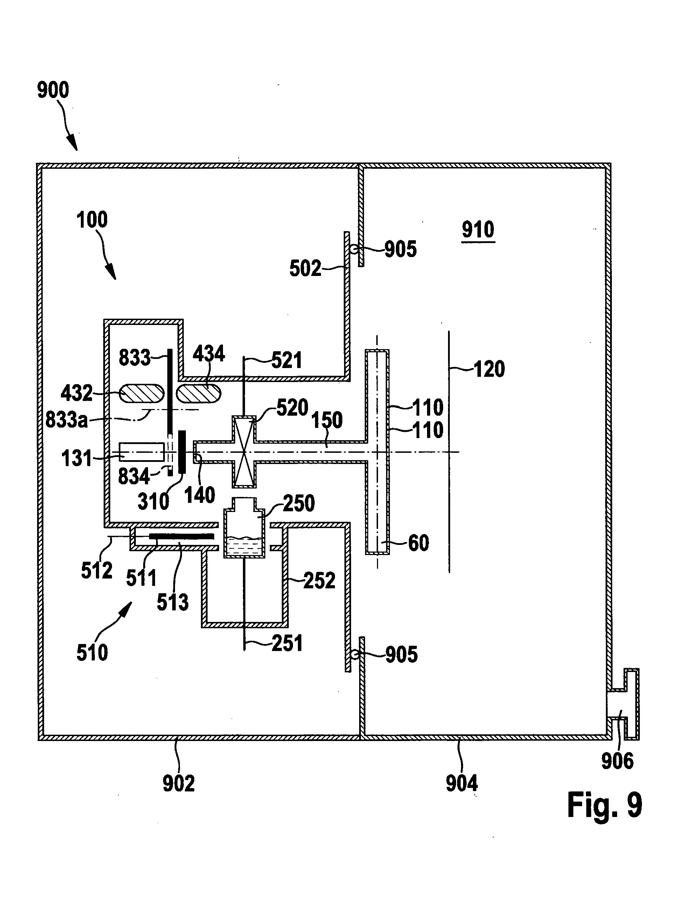

Figure 9 shows an evaporation apparatus 900 including an evaporator 100 according to any of the embodiments described herein. The apparatus 900 includes a first housing portion 904, which forms, together with the housing portion 502 of the evaporator, a vacuum area 910. Typically, one or more seals 905, such as O-rings, can be provided. Further, a vacuum flange 906 can be provided for connecting an evacuation system such as a vacuum pump. In typical, the organic vapor is applied to the substrate 120 in a vacuum atmosphere. The term vacuum shall refer to a pressure of 1 Pa and below. The apparatus may 900 may optionally further include a further housing portion 902, which does not necessarily need to be evacuated and which can be used to enclose portions of an electrical cabinet and other control assemblies, such as the controller 330, which has been described above.

According to some embodiments, which can be combined with other embodiments described herein, the crucible 250 can be moved out of and moved into a crucible chamber 252, which can be locked by a crucible valve shutter assembly 510. For example, the crucible shutter assembly can include a shutter housing 513, in which the shutter 511 can be moved by actuator 512. According to some embodiments, the crucible chamber 252 and an enclosure of the chamber portion 502 have an opening for passing the crucible 250 therethrough, i.e., from a position within the crucible chamber 252 to a position at which the crucible is connected to the supply tube. Thereby, the system can be maintained in an evacuated state during exchange of the crucible and/or the material to be deposited. If the crucible is provided in the position within the crucible chamber (the lower position in Fig. 9), the shutter 511, typically a vacuum valve, can be closed such that the crucible chamber 252 can be opened for an exchange of the crucible and/or re-filling of the material therein. Further, according to some embodiments, which can be combined with other embodiments described herein, the valve 520 can be moved from a closed position to an open position with actuator 521. If the valve 520 is in a closed position, no or only little vapor can enter the supply tube and, thus, the distribution manifold 60 and the measurement region respectively. In an open position of valve 520, the material, which is evaporated in crucible 252, can enter the supply tube 150 for being guided towards the substrate 120 and towards the measurement region.

A vapor guiding means, i.e., the supply tube 150 and the distribution manifold 60, is further provided with a measurement outlet 140. During operation, when the crucible 250 is connected to the supply tube 150, one portion of the incoming vapor is guided into the distribution manifold 60, e.g., a distribution pipe. Another portion of the vapor is guided towards the measurement systems. The division of the vapor is typically designed such that a larger amount of vapor is guided into the evaporation section 80, typically about 70 % to 99.5 %, more typically 80 % to 97 %. Respectively, a much smaller amount is guided into the measurement section. As shown in Fig. 9, and similar to Fig. 8, a test substrate 833 is provided by a rotatable test substrate 833, which is configured to be rotated around axis 833a. Further, the test substrate 833 has an opening aperture 834. In a first angular position, the aperture 834 is provided such that the material from the measurement outlet 140 can pass through the opening aperture in order to expose the first measurement system 131 to the portion of the evaporated material which is intended for the deposition rate measurement. In one or more other angular positions of the rotatable test substrate 833, a portion of the test substrate is positioned in front of the measurement outlet for coating the test substrate. Thereby, a layer thickness of the coated layer on the test substrate or a layer thickness increase of the coated layer on the test substrate can be measured by measuring device 332.

As shown in Fig. 9, the second measurement system typically includes light source 432 which can be, for instance, a laser or a traditional white or colored light source having a specific spectral distribution as described herein and a light detector 434 as described herein. It is also possible that the light source referred to as reference numeral 432 can be the end of a fiber optic cable. In other words, in embodiments of the present invention, there may be a fiber optics arranged for transmitting the light to the test substrate 333. The detectors could also be connected via fiber optics. According to typical embodiments, which can be combined with other embodiments described herein, the measuring with the optical measurement system is selected from the group consisting of: an optical absorption measurement; an interferometer measurement; and ellipsometry measurement; an optical reflection measurement; an optical transmission measurement; a photoluminescence measurement; an optical reflection measurement in wavelength range including wavelength below 400 nm; an optical transmission measurement in wavelength range including wavelength below 400 nm; and combinations thereof.

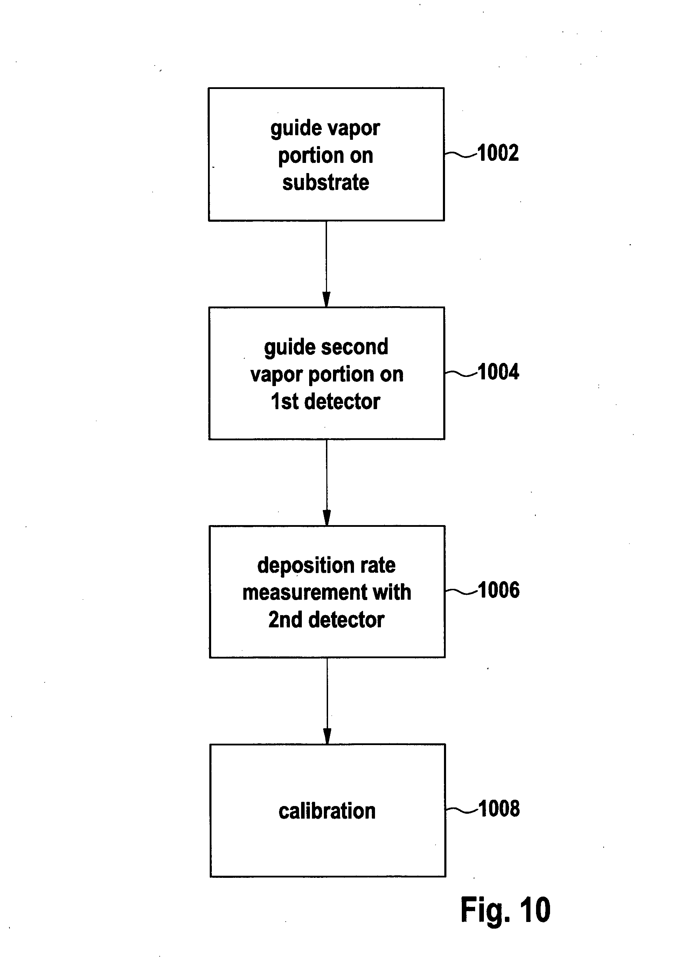

Figure 10 illustrates further embodiments relating to a method of operating an evaporation apparatus for evaporating a material, e.g., an organic material. In step 1002, a first portion of evaporated material is guided onto a substrate via opening nozzles. Thereby, a substrate is coated as desired. Typically, the substrate can be masked for coating such that the evaporated material is only deposited on the substrate in a predetermined area or in predetermined areas.

A second portion of evaporated material is guided onto a first detector via a measurement outlet in step 1004. According to typical implementations thereof, a shutter can be used to allow exposure of the first detector only in a time period during which the shutter does not block the second portion of evaporated material. Thereby, for example, the amount of evaporated material which is deposited on the first detector is reduced in order to provide for a longer operation life of the first detector. According to yet further embodiments, the first detector can also be one detector of a plurality of detectors. According to some embodiments, which can be combined with other embodiments described herein, four or more, for example, ten or 12, or even more detectors (e.g., quartz crystals) can be provided in a first measurement system. These detectors can be used one after the other such that the operation lifer can be further increased.

In step 1006, a second detector or a component of a second measurement system such as a test substrate is provided for a deposition rate measurement. For example, a test substrate portion can be moved between the measurement outlet and the first detector to deposit the test substrate portion with the second portion of evaporated material, the test substrate portion can be removed from between the measurement outlet and the first detector to again guide the second portion of evaporated material onto the first detector via the measurement outlet and a signal corresponding with a layer thickness of the layer of evaporated material deposited on the test substrate portion can be measured, e.g., with an optical measurement system.

In step 1008, the signal of the second measurement system or the second detector, respectively can be utilized for calibration of the first detector. Even though, the first measurement system might provide the desired accuracy, the operation life is generally not sufficient even if more than one detector is provided. Accordingly, if a sudden drop or raise of a signal of the first measurement system is provided, the second signal of the second measurement system can be used to have a calibration from an independent measurement system.

According to typical embodiments, a shutter for selectively blocking the measurement portion of the evaporated material can be used. The shutter can be used for blocking evaporated material during predetermined time periods when a measurement with the first measurement system is conducted. Further, the shutter can be closed when a test substrate is moved in the measurement portion of evaporated material, can be opened for coating the test substrate and can be closed for re-moving the test substrate. Thereby, the test substrate can be coated for a predetermined timer period, for example, in the range of 5s to 30s. Further typically, guiding the second portion of evaporated material onto the first detector is conducted at least every 30 min, particularly at least every 10 min; and wherein the moving and re-moving of the test-substrate is conducted based on an event selected from the group consisting of: a signal drop of the first detector, an exchange of the first detector, and an alert status of the evaporation apparatus and/or is conducted at most every hour, particularly at most every 12 hours.

Typically, the measuring with the optical measurement system is selected from the group consisting of: an optical absorption measurement; an interferometer measurement; and ellipsometry measurement; an optical reflection measurement; an optical transmission measurement; a photoluminescence measurement; an optical reflection measurement in wavelength range including wavelength below 400 nm and/or above 300 nm; an optical transmission measurement in wavelength range including wavelength below 400 nm and/or above 300 nm; and combinations thereof. According to yet further embodiments, which can be combined with other embodiments described herein, the guiding of the second portion of evaporated material onto the first detector is conducted at least every 30 min, particularly at least every 10 min; and wherein the moving and removing of the test-substrate is conducted based on an event selected from the group consisting of: a signal drop of the first detector, an exchange of the first detector, and an alert status of the evaporation apparatus and/or is conducted at most every hour, particularly at most every 12 hours.

According to yet further embodiments, which can be combined with other embodiments described herein, the measuring with the second measurement system includes measuring of a layer thickness difference of a layer thickness before moving the substrate and after removing the substrate. Thereby, a test substrate can be coated at a specific portion more than once as the deposition rate relates to the layer thickness difference. Yet further, a measuring with the optical measurement system can, according to some embodiments, be selected from the group consisting of: an optical absorption measurement; an interferometer measurement; and ellipsometry measurement; a photoluminescence measurement; an optical reflection measurement; an optical transmission measurement; an optical reflection measurement in wavelength range including wavelength below 400 nm; an optical transmission measurement in wavelength range including wavelength below 400 nm; and combinations thereof.

## Claims

1. An evaporator for evaporating a material onto a substrate, comprising:
a guiding means for guiding the material towards at least one opening nozzle, the guiding means comprises
a measurement outlet for a portion of the material;
the evaporator further comprising:
a first measurement system configured for generating a first signal correlated with a deposition rate of the evaporator and having a first detector positioned for being coated by the material; and
a second optical measurement system for generating a second signal correlated with the deposition rate of the evaporator and wherein the second signal is based on the portion of the material of the measurement outlet.

2. The evaporator according to claim 1, wherein the measurement outlet for the portion of the material has an evaporation direction different from the evaporation direction of the at least one opening nozzle.

3. The evaporator of any of claims 1 to 2, wherein the guiding means comprises a supply tube and a distribution manifold, particularly a distribution pipe, and wherein the at least one opening nozzle is provided in the distribution manifold.

4. The evaporator of any of claims 1 to 3, wherein the second measurement system is configured for measuring a layer thickness.

5. The evaporator of any of claims 1 to 4, further comprising:
a controller connected to the second measurement system to receive the second signal and, wherein the controller is configured for calibrating the first measurement system.

6. The evaporator of any of claims 1 to 5, further comprising:
a substrate support for a test substrate, wherein the substrate support is configured for holding a substrate during coating with the portion of the material.

7. The evaporator of claim 6, wherein the substrate support includes an actuator for moving a portion of the test substrate from a position between the measurement outlet and the first detector to a position for coating the first detector.

8. The evaporator of any of claims 1 to 7, further comprising:
a shutter for selectively blocking the portion of the material.

9. The evaporator of any of claims 2 to 8, wherein the measurement outlet is provided in the supply tube.

10. The evaporator of any of claims 1 to 9, wherein first detector comprises at least one oscillating crystal or four or more oscillating crystals and wherein the second measurement system comprises a source for electromagnetic radiation and a detector for electromagnetic radiation.

11. The evaporator of any of claims 2 to 10, wherein the second measurement system comprises a source for electromagnetic radiation and a detector for electromagnetic radiation and being configured for measuring a thickness of a layer of the material on the test substrate.

12. An evaporation apparatus for depositing material on a substrate, comprising:
a chamber for depositing the material on the substrate; and
an evaporator according to any of claims 1 to 11, wherein the evaporator is provided within the chamber.

13. A method of operating an evaporation apparatus for evaporating a material,
comprising:
guiding a first portion of evaporated material onto a substrate via opening nozzles;
guiding a second portion of evaporated material onto a first detector via a measurement outlet;
positioning a second optical measurement system with respect to the second portion of the evaporated material such that a signal corresponding to a deposition rate of evaporated material can be generated, wherein positioning the second measurement system comprises providing a second detector,
the method further comprises:
using the signal for calibration of the first detector.

14. The method according to claim 13, wherein providing the second detector comprises
moving a test substrate portion between the measurement outlet and the first detector to deposit the test substrate portion with the second portion of evaporated material;
removing the test substrate portion from between the measurement outlet and the first detector to again guide the second portion of evaporated material onto the first detector via the measurement outlet; and
measuring a signal corresponding with a layer thickness of the layer of evaporated material deposited on the test substrate portion with an optical measurement system.

15. The method according to any of claims 13 to 14, further comprising:
moving a shutter for selectively blocking the second portion of material.

16. The method according to any of claims 13 to 15, wherein the measuring includes measuring of a layer thickness difference of a layer thickness before moving the substrate and after removing the substrate.

17. The method according to any of claims 13 to 16, wherein the measuring with the optical measurement system is selected from the group consisting of: an optical absorption measurement; an interferometer measurement; and ellipsometry measurement; an optical reflection measurement; an optical transmission measurement; a photoluminescence measurement; an optical reflection measurement in wavelength range including wavelength below 400 nm; an optical transmission measurement in wavelength range including wavelength below 400 nm; and combinations thereof.

## Patentansprüche

1. Verdampfer zum Aufdampfen eines Materials auf ein Substrat, Folgendes aufweisend:
eine Leitungseinrichtung zum Leiten des Materials zu mindestens einer Öffnungsdüse, wobei die Leitungseinrichtung aufweist:
einen Messauslass für einen Teil des Materials;
wobei der Verdampfer darüber hinaus aufweist:
ein erstes Messsystem, das dazu ausgelegt ist, ein erstes Signal zu generieren, das mit einer Abscheidungsrate des Verdampfers korreliert ist, und über einen ersten Detektor verfügt, der dazu angeordnet ist, mit dem Material beschichtet zu werden, und
ein zweites, optisches Messsystem zum Generieren eines zweiten Signals, das mit der Abscheidungsrate des Verdampfers korreliert ist, und wobei das zweite Signal auf dem Teil des Materials des Messauslasses beruht.

2. Verdampfer nach Anspruch 1, wobei der Messauslass für den Teil des Materials eine Verdampfungsrichtung hat, die sich von der Verdampfungsrichtung der mindestens einen Öffnungsdüse unterscheidet.

3. Verdampfer nach einem der Ansprüche 1 bis 2, wobei die Leitungseinrichtung ein Zufuhrrohr und eine Verteilungssammelleitung, insbesondere ein Verteilungsrohr aufweist, und wobei die mindestens eine Öffnungsdüse in der Verteilungssammelleitung angeordnet ist.

4. Verdampfer nach einem der Ansprüche 1 bis 3, wobei das zweite Messsystem zum Messen einer Schichtdicke ausgelegt ist.

5. Verdampfer nach einem der Ansprüche 1 bis 4, darüber hinaus aufweisend:
eine Steuerung, die an das zweite Messsystem angeschlossen ist, um das zweite Signal zu empfangen, und wobei die Steuerung zum Kalibrieren des ersten Messsystems ausgelegt ist.

6. Verdampfer nach einem der Ansprüche 1 bis 5, darüber hinaus aufweisend:
eine Substrathalterung für ein Testsubstrat, wobei die Substrathalterung zum Haltern eines Substrats während der Beschichtung mit dem Teil des Materials ausgelegt ist.

7. Verdampfer nach Anspruch 6, wobei die Substrathalterung ein Stellglied zum Bewegen eines Abschnitts des Testsubstrats von einer Position zwischen dem Messauslass und dem ersten Detektor zu einer Position zum Beschichten des ersten Detektors aufweist.

8. Verdampfer nach einem der Ansprüche 1 bis 7, darüber hinaus aufweisend:
einen Verschluss zum selektiven Blockieren des Teils des Materials.

9. Verdampfer nach einem der Ansprüche 2 bis 8, wobei der Messauslass im Zufuhrrohr angeordnet ist.

10. Verdampfer nach einem der Ansprüche 1 bis 9, wobei der erste Detektor mindestens einen Schwingungskristall oder vier oder mehr Schwingungskristalle aufweist, und wobei das zweite Messsystem eine Quelle für elektromagnetische Strahlung und einen Detektor für elektromagnetische Strahlung aufweist.

11. Verdampfer nach einem der Ansprüche 2 bis 10, wobei das zweite Messsystem eine Quelle für elektromagnetische Strahlung und einen Detektor für elektromagnetische Strahlung aufweist und zum Messen einer Dicke einer Schicht des Materials auf dem Testsubstrat ausgelegt ist.

12. Verdampfungsvorrichtung zum Abscheiden von Material auf einem Substrat, Folgendes aufweisend:
eine Kammer zum Abscheiden des Materials auf dem Substrat; und
einen Verdampfer nach einem der Ansprüche 1 bis 11, wobei der Verdampfer in der Kammer vorgesehen ist.

13. Verfahren zum Betreiben einer Verdampfungsvorrichtung zum Aufdampfen eines Materials, Folgendes umfassend:
Leiten eines ersten Teils verdampften Materials über Öffnungsdüsen auf ein Substrat;
Leiten eines zweiten Teils verdampften Materials über einen Messauslass auf einen ersten Detektor;
Anordnen eines zweiten optischen Messsystems in Bezug auf den zweiten Teil des verdampften Materials derart, dass ein einer Abscheidungsrate verdampften Materials entsprechendes Signal generiert werden kann, wobei das Anordnen des zweiten Messsystems umfasst, einen zweiten Detektor bereitzustellen,
wobei das Verfahren darüber hinaus umfasst:
Verwenden des Signals zur Kalibrierung des ersten Detektors.

14. Verfahren nach Anspruch 13, wobei das Bereitstellen des zweiten Detektors umfasst:
Bewegen eines Testsubstratabschnitts zwischen dem Messauslass und dem ersten Detektor, um den Testsubstratabschnitt mit dem zweiten Teil des verdampften Materials zu belegen;
Entfernen des Testsubstratabschnitts zwischen dem Messauslass und dem ersten Detektor, um den zweiten Teil verdampften Materials wieder über den Messauslass auf den ersten Detektor zu leiten; und
Messen eines Signals, das mit einer Schichtdicke der Schicht verdampften Materials übereinstimmt, das auf dem Testsubstratabschnitt abgeschieden ist, mit einem optischen Messsystem.

15. Verfahren nach einem der Ansprüche 13 bis 14, darüber hinaus umfassend:
Bewegen eines Verschlusses zum selektiven Blockieren des zweiten Materialteils.

16. Verfahren nach einem der Ansprüche 13 bis 15, wobei das Messen umfasst, einen Schichtdickenunterschied einer Schichtdicke zu messen, bevor das Substrat bewegt wird, und nachdem des Substrat entfernt wurde.

17. Verfahren nach einem der Ansprüche 13 bis 16, wobei das Messen mit dem optischen Messsystem aus der Gruppe ausgewählt ist, die besteht aus: einer optischen Absorptionsmessung; einer Interferometermessung; und Ellipsometriemessung; einer optischen Reflexionsmessung; einer optischen Transmissionsmessung; einer Fotolumineszenzmessung; einer optischen Reflexionsmessung in einem Wellenlängenbereich einschließlich einer Wellenlänge unter 400 nm; einer optischen Transmissionsmessung in einem Wellenlängenbereich einschließlich einer Wellenlänge unter 400 nm; und einer Kombination aus diesen.

## Revendications

1. Évaporateur destiné à évaporer un matériau sur un substrat, comprenant :
un moyen de guidage destiné à guider le matériau vers au moins une buse d'ouverture, le moyen de guidage comprenant
une sortie de mesure pour une partie du matériau ;
l'évaporateur comprenant en outre :
un premier système de mesure configuré pour générer un premier signal corrélé à une cadence de dépôt de l'évaporateur et comportant un premier détecteur positionné pour être recouvert par le matériau ; et
un deuxième système de mesure optique destiné à générer un deuxième signal corrélé à la cadence de dépôt de l'évaporateur et dans lequel le deuxième signal est basé sur la partie du matériau de la sortie de mesure.

2. L'évaporateur selon la revendication 1, dans lequel la sortie de mesure pour la partie du matériau a une direction d'évaporation différente de la direction d'évaporation de l'au moins une buse d'ouverture.

3. L'évaporateur de l'une quelconque des revendications 1 à 2, dans lequel le moyen de guidage comprend un tube d'alimentation et un collecteur de distribution, en particulier un tuyau de distribution, et dans lequel l'au moins une buse d'ouverture est disposée dans le collecteur de distribution.

4. L'évaporateur de l'une quelconque des revendications 1 à 3, dans lequel le deuxième système de mesure est configuré pour mesurer une épaisseur de couche.

5. L'évaporateur de l'une quelconque des revendications 1 à 4, comprenant en outre :
une unité de commande connectée au deuxième système de mesure pour recevoir le deuxième signal, l'unité de commande étant configurée pour calibrer le premier système de mesure.

6. L'évaporateur de l'une quelconque des revendications 1 à 5, comprenant en outre :
un support de substrat pour un substrat d'essai, le support de substrat étant configuré pour maintenir un substrat pendant le revêtement avec la partie du matériau.

7. L'évaporateur de la revendication 6, dans lequel le support de substrat inclut un actionneur destiné à déplacer une partie du substrat d'essai d'une position située entre la sortie de mesure et le premier détecteur à une position prévue pour revêtir le premier détecteur.

8. L'évaporateur de l'une quelconque des revendications 1 à 7, comprenant en outre :
un clapet destiné à bloquer sélectivement la partie du matériau.

9. L'évaporateur de l'une quelconque des revendications 2 à 8, dans lequel la sortie de mesure est disposée dans le tube d'alimentation.

10. L'évaporateur de l'une quelconque des revendications 1 à 9, dans lequel le premier détecteur comprend au moins un cristal oscillant ou quatre cristaux oscillants ou plus et dans lequel le deuxième système de mesure comprend une source de rayonnement électromagnétique et un détecteur de rayonnement électromagnétique.

11. L'évaporateur de l'une quelconque des revendications 2 à 10, dans lequel le deuxième système de mesure comprend une source de rayonnement électromagnétique et un détecteur de rayonnement électromagnétique et est configuré pour mesurer une épaisseur d'une couche du matériau sur le substrat d'essai.

12. Dispositif d'évaporation destiné à déposer du matériau sur un substrat, comprenant :
une chambre pour le dépôt du matériau sur le substrat ; et
un évaporateur selon l'une quelconque des revendications 1 à 11, l'évaporateur étant disposé à l'intérieur de la chambre.

13. Procédé d'exploitation d'un dispositif d'évaporation destiné à évaporer un matériau, comprenant :
le guidage d'une première partie de matériau évaporé sur un substrat via des buses d'ouverture ;
le guidage d'une deuxième partie de matériau évaporé sur un premier détecteur via une sortie de mesure ;
le positionnement d'un deuxième système de mesure optique par rapport à la deuxième partie du matériau évaporé de telle sorte qu'un signal correspondant à une cadence de dépôt de matériau évaporé puisse être généré, le positionnement du deuxième système de mesure comprenant la fourniture d'un deuxième détecteur,
le procédé comprenant en outre :
l'utilisation du signal pour le calibrage du premier détecteur.

14. Le procédé selon la revendication 13, dans lequel la fourniture du deuxième détecteur comprend
le déplacement d'une partie de substrat d'essai entre la sortie de mesure et le premier détecteur pour déposer la partie de substrat d'essai avec la deuxième partie de matériau évaporé ;
l'enlèvement de la partie de substrat d'essai d'entre la sortie de mesure et le premier détecteur pour guider de nouveau la deuxième partie de matériau évaporé sur le premier détecteur via la sortie de mesure ; et
la mesure d'un signal correspondant à une épaisseur de couche de la couche de matériau évaporé déposé sur la partie de substrat d'essai avec un système de mesure optique.

15. Le procédé selon l'une quelconque des revendications 13 à 14, comprenant en outre :
le déplacement d'un clapet destiné à bloquer sélectivement la deuxième partie de matériau.

16. Le procédé selon l'une quelconque des revendications 13 à 15, dans lequel la mesure inclut la mesure d'une différence d'épaisseur de couche d'une épaisseur de couche avant le déplacement du substrat et après l'enlèvement du substrat.

17. Le procédé selon l'une quelconque des revendications 13 à 16, dans lequel la mesure avec le système de mesure optique est sélectionnée dans le groupe constitué par : une mesure par absorption optique ; une mesure par interféromètre ; une mesure par ellipsométrie ; une mesure par réflexion optique ; une mesure par transmission optique ; une mesure par photoluminescence ; une mesure par réflexion optique dans une plage de longueur d'onde incluant une longueur d'onde inférieure à 400 nm ; une mesure par transmission optique dans une plage de longueur d'onde incluant une longueur d'onde inférieure à 400 nm ; et des combinaisons de celles-ci.
